# EUROPÄISCHE PATENTSCHRIFT

(11) **EP 1 712 749 B1**
(45) Veröffentlichungstag und Bekanntmachung des Hinweises auf die Patenterteilung: **12.10.2011**
(21) Anmeldenummer: 06002998.0
(22) Anmeldetag: 15.02.2006
(51) Int. Cl.: F01L 13/00, F01L 1/14

(54) **Schaltbares Ventiltriebbauteil**
Switchable valve lifter
Poussoir de soupape désactivable

(30) Priorität: 11.04.2005 US 670559 P
(43) Veröffentlichungstag der Anmeldung: 18.10.2006
(73) Patentinhaber: Schaeffler Technologies GmbH & Co. KG, 91074 Herzogenaurach (DE)
(72) Erfinder: Evans, Matthew, 48092 Warren MI (US); Jones, Jermel, 48076 Southfield MI (US); Hosenfeldt, Tim Matthias, Dr., 96106 Ebern (DE); Sailer, Peter, 91052 Erlangen (DE); Schnell, Oliver, 90587 Veitsbronn (DE)

(56) Entgegenhaltungen:
- EP-A- 1 380 667
- EP-A- 1 505 266
- EP-A- 1 505 322
- WO-A-03/076770
- DE-A1- 4 127 639
- DE-A1- 19 625 329
- JP-A- 2003 027 214
- US-A1- 2003 101 953

## Beschreibung

### Gebiet der Erfindung

Die vorliegende Erfindung bezieht sich auf ein schaltbares Ventiltriebbauteil zur variablen Übertragung eines von einer oder mehreren Nockenerhebungen erzeugten Hubes auf wenigstens ein Gaswechselventil einer Brennkraftmaschine. Das Ventiltriebbauteil weist mindestens zwei Übertragungsglieder auf, die durch ein oder mehrere Koppelelemente in Übertragungsrichtung formschlüssig verbindbar sind, indem Kraftübertragungsflächenabschnitte der Koppelelemente zwischen Kraftübertragungsflächenabschnitten der Übertragungsglieder einspannbar sind.

### Hintergrund der Erfindung

Gattungsgemäße Ventiltriebbauteile sind im Stand der Technik als wirksame Mittel bekannt, das Kraftstoffverbrauchs-, Leistungs- und Abgasemissionsverhalten von Brennkraftmaschinen gezielt zu optimieren. Derartige Ventiltriebbauteile besitzen üblicherweise betriebspunktabhängig verlagerbare Koppelelemente, mit denen die Übertragungsglieder der Ventiltriebbauteile in Übertragungsrichtung formschlüssig verbindbar sind.

Hierzu zählen zunächst die im Kraftfluss zwischen einer Nockenwelle der Brennkraftmaschine und den Gaswechselventilen angeordneten schaltbaren Nockenfolger. Mit diesen können diskrete, auf den Betriebszustand der Brennkraftmaschine abgestimmte Nockenerhebungen selektiv auf ein Gaswechselventil übertragen oder zur Stilllegung des Gaswechselventils vollständig ausgeblendet werden. Einen guten Überblick über schaltbare Nockenfolger kann sich der Fachmann beispielsweise mit dem Handbuch "Verbrennungsmotor", das als erste Auflage im April 2002 im Vieweg-Verlag erschien, verschaffen. Dort sind im Kapitel 10.4.2, Seite 357 ff. für den Serieneinsatz ausgeführte Systeme mit stufenweiser Hub- und Öffnungsdauervariation des Gaswechselventils beschrieben. Dargestellt sind schaltbare Schwing- und Kipphebel sowie ein schaltbarer Tassenstößel, die über hydraulisch betätigte Koppelelemente zur Verriegelung der Übertragungsglieder verfügen und zur Umschaltung oder Abschaltung des Gaswechselventilhubs dienen. Weiterhin ist in der WO 2004/094791 A1 ein schaltbarer Schlepphebel sowie in der DE 102 04 673 A1 ein schaltbarer Rollenstößel für einen Stößelstangen-Ventiltrieb - beide mit hydraulisch betätigten Koppelelementen - vorgeschlagen. Unter einem schaltbaren Nockenfolger versteht der Fachmann schließlich auch ein in der Brennkraftmaschine ruhend gelagertes Abstützelement, wie es beispielsweise in der DE 44 04 145 A1 vorgeschlagen ist.

Zu den gattungsgemäßen Ventiltriebbauteilen gehören weiterhin auch die Steuerzeiten von Gaswechselventilen verändernden Nockenwellenversteller, die ein oder mehrere Koppelelemente zur Verriegelung eines Stators als antriebseitiges Übertragungsglied mit einem Rotor als abtriebseitiges Übertragungsglied aufweisen. Ein solches Koppelelement hält bei hydraulisch betätigten Nockenwellenverstellern vorrangig die für den Startvorgang der Brennkraftmaschine erforderlichen Steuerzeiten aufrecht, da in diesem Betriebszustand noch kein ausreichender Hydraulikmitteldruck zur Versorgung des Nockenwellenverstellers zur Verfügung steht. Weitere Details und Ausführungen sind beispielsweise in dem Buch "Nockenwellenverstellungen für Ottomotoren" auf Seite 44 ff. beschrieben. Dieses Buch erschien im Jahr 2002 im Verlag Modeme Industrie.

Schließlich sind schaltbare Nockenwellen zu nennen, die über Nocken mit gegeneinander verstellbaren und mittels Koppelelementen verriegelbaren Nockensegmenten als Übertragungsglieder verfügen. Eine derartige Nockenwelle geht unter anderem aus der WO 2004/109068 A1 hervor.

Allen genannten Ventiltriebbauteilen liegt das Prinzip zugrunde, deren Übertragungsglieder durch betriebspunktabhängig verlagerbare Koppelelemente in Übertragungsrichtung formschlüssig zu verbinden. Im Hinblick auf eine einwandfreie Funktion der schaltbaren Ventiltriebbauteile über der Lebensdauer der Brennkraftmaschine kommt der Gestaltung der Koppelelemente und ihrer Kontaktpartner in den Übertragungsgliedern höchste Bedeutung zu. Eine wesentliche Zielsetzung dabei ist eine dauerhaft leichtgängige Verlagerbarkeit der Koppelelemente als Voraussetzung für deren reproduzierbaren Umschaltvorgang, der bei schaltbaren Nockenfolgern oder schaltbaren Nockenwellen auch bei höchsten Drehzahlen und/oder bei kalter Brennkraftmaschine mit hochviskosem Schmieröl innerhalb einer Nockengrundkreisphase abgeschlossen sein soll. Hierzu sind hydraulisch betätigte Koppelelemente üblicherweise in einer engen Spielpassung geführt, um einen schnellen Druckaufbau vor den Koppelelementen zu erzeugen, wobei aufgrund der engen Spielpassung gleichzeitig ein geringes und gering streuendes mechanisches Spiel innerhalb der schaltbaren Ventiltriebbauteile gewährleistet werden kann. Da der Öffnungsverlauf der Gaswechselventile gegenüber der zugehörigen Nockenerhebung durch das mechanische Spiel verändert wird, ist es eine weitere Zielsetzung, das mechanische Spiel und dessen Streuung insbesondere bei schaltbaren Nockenfolgern so konstant wie möglich über der Lebensdauer der Brennkraftmaschine zu halten, um möglichst gleichmäßige und konstante Öffnungsverläufe aller Gaswechselventile der Brennkraftmaschine zu generieren. Dies ist beispielsweise Voraussetzung für eine dauerhaft gute Leerlaufqualität der Brennkraftmaschine, die besonders in diesem Betriebspunkt sensibel auf Änderungen der Steuerzeiten gleichzeitig geöffneter Einlass- und Auslassventile reagiert.

Eine wesentliche Voraussetzung für die dauerhaft leichtgängige Verlagerbarkeit sowie das möglichst konstante mechanische Spiel der Koppelelemente ist die Form- und Oberflächenbeständigkeit der Koppelelemente und deren Kontaktpartner in den Übertragungsgliedern. Insofern dürfen auch höchste Oberflächenbeanspruchungen weder zu einer nennenswerten Deformation noch zu einem nennenswerten Verschleiß der beanspruchten Oberflächen führen. Diese Oberflächenbeanspruchungen resultieren zunächst aus Materialspannungen im Bereich Hertz scher Pressungskontakte oder im Bereich von Kantenträgern, die zwischen Koppelelementen und Übertragungsgliedern beispielsweise im Bereich der von den Koppelelementen überspannten Trennfugen zwischen den Übertragungsgliedern auftreten. Weiterhin kommt es unter dynamischer Beanspruchung der zwischen den Übertragungsgliedern eingespannten Koppelelemente zu gegenseitigen Mikrobewegungen der beteiligen Oberflächen, die bei einem mangelhaften Schmierölfilm und/oder bei einem vergleichsweise hohen Anteil abrasiv wirkender Partikel im Schmieröl einem erheblichen Risiko eines unzulässig hohen adhäsiven und/oder abrasiven Verschleißes ausgesetzt sind. Diese Partikel können beispielsweise Rußpartikel als Produkt einer unvollständigen Verbrennung der Brennkraftmaschine sein, die über das so genannte Blow-by in das Kurbelgehäuse und somit über das Schmieröl zu den Koppelelementen gelangen.

Diesem Verschleißrisiko sind besonders dynamisch hochbelastete schaltbare Ventiltriebbauteile wie beispielsweise Nockenfolger mit vergleichsweise hoher bewegter Masse ausgesetzt. Hierzu zählen in erster Linie schaltbare Rollenstößel für Stößelstangen-Ventiltriebe oder auch schaltbare Schlepphebel, bei denen es zu unzulässig hohem Verschleiß und Verschleißfortschritt der Koppelelemente und ihrer Kontaktpartner in den Übertragungsgliedern während des Betriebs der Brennkraftmaschine kommen kann. Aus dem einschlägigen und eingangs beispielhaft zitierten Stand der Technik sind der Anmelderin jedoch keine Mittel bekannt, diese Problematik unter Berücksichtigung von Herstellungs- und Kostenaspekten einer Großserienfertigung zu beseitigen.

In der WO 03/076770 A1 ist es am Beispiel eines schaltbaren Rollenstößels vorgeschlagen, den betrieblichen Verschleißfortschritt der Koppelelemente und ihrer Kontaktpartner dadurch zu reduzieren, dass die Kraftübertragungsflächen während der Montage des Rollenstößels einem Vorverschleiß unterzogen werden. Hierdurch soll der Einstellbereich des Verriegelungsspiels erhöht werden.

Im Stand der Technik sind für Ventiltriebbauteile vorgesehene Verschleißschutzschichten in Form diamantharter Kohlenwasserstoffschichten, kurz DLC-Schichten bekannt. In der JP 2003 027214 A ist eine metallhaltige Kohlenwasserstoffschicht vorgeschlagen, die auf einer Zwischenschicht aufgebracht ist. Bei der Zwischenschicht handelt es sich um eine metallische Schicht oder eine wasserstofffreie Kohlenstoffschicht. Aus der DE 196 25 329 A1 geht eine reine Kohlenstoffschicht hervor, die auf einer Zwischenschicht aufgebracht ist. Dabei handelt es sich vorzugsweise um ein Carbid, Nitrid oder Borid eines Übergangsmetalls. Die EP 1 380 667 A1 offenbart eine DLC-Schicht, die auf einer Wolfram enthaltenden Haftvermittlungsschicht und einer Zwischenschicht aus Wolfram aufgebracht ist.

### Aufgabe der Erfindung

Es ist Aufgabe der vorliegenden Erfindung, ein schaltbares Ventiltriebbauteil zu schaffen, bei dem die Koppelelemente sowie deren Kontaktpartner ausreichend gegen adhäsiven und insbesondere gegen abrasiven Verschleiß geschützt sind.

### Zusammenfassung der Erfindung

Erfindungsgemäß wird diese Aufgabe dadurch gelöst, dass zumindest einer der Kraftübertragungsflächenabschnitte mit einer Verschleißschutzschicht versehen ist, die aus mindestens einer metallfreien amorphen Kohlenwasserstoffschicht mit sp²- und sp³-hybridisiertem Kohlenstoff besteht, wobei zwischen dem zumindest einen der Kraftübertragungsflächenabschnitte und der Verschleißschutzschicht wenigstens eine Zwischenschicht vorgesehen ist, die als metallhaltige Kohlenwasserstoffschicht, deren Metallkomponenten aus W, Ti, Hf, Ge oder einer Kombination der vorgenannten Komponenten bestehen, ausgebildet ist und eine Dicke von etwa 0,5 µm bis 2,0 µm aufweist.

Der mit der amorphen Kohlenwasserstoffschicht beschichtete Kraftübertragungsflächenabschnitt zeichnet sich neben der geforderten Verschleißbeständigkeit auch durch einen reduzierten Reibkoeffizienten aus. Dies hat den zusätzlichen Vorteil, dass die Verlagerungsgeschwindigkeit der Koppelelemente weiter erhöht werden kann, so dass auch bei sehr hohen Drehzahlen der Brennkraftmaschine mit entsprechend zeitlich kurzer Nockengrundkreisphase ein ausreichend schneller und reproduzierbarer Umschaltvorgang des Ventiltriebbauteils gewährleistet werden kann.

Gemäß einer bevorzugten Weiterbildung der Erfindung weist die amorphe Kohlenwasserstoffschicht einen Wasserstoffanteil von maximal 16 Atom-% und prozessbedingte Verunreinigungen, beispielsweise in Form von O- oder Ar-Atomen, Metallen oder dergleichen, von weniger als 1 Atom-% auf. Dadurch besitzen Kraftübertragungsflächenabschnitte, die mit der Verschleißschutzschicht versehen sind, bei hoher abrasiver Verschleißbeständigkeit eine geringe Adhäsionsneigung zu einem metallischen Gegenkörper in Form eines nicht beschichteten Kraftübertragungsflächenabschnitts. Gleichzeitig ist eine derartige Kohlenwasserstoffschicht durch eine hohe chemische Beständigkeit, hohe mechanische Festigkeiten und hohe Härte/E-Modulverhältnisse gekennzeichnet. Ein höherer Wasserstoffanteil könnte zu unerwünschten Verbindungen mit Schmiermitteln oder dergleichen führen.

Die amorphe Kohlenwasserstoffschicht soll weiterhin eine Dicke von 0,8 µm bis 2,5 µm besitzen. Dabei kann gemäß einem weiteren bevorzugten Ausführungsbeispiel zwischen dem Kraftübertragungsflächenabschnitt und der Zwischenschicht wenigstens eine Haftvermittlungsschicht vorgesehen sein. Die Haftvermittlungsschicht besteht zweckmäßigerweise aus metallischen Stoffen, Boriden, Carbiden und/oder Nitriden der Übergangsmetalle und weist eine Dicke von etwa 0,1 µm bis 0,5 µm auf.

In einer besonders bevorzugten Ausführungsform der Erfindung soll das Ventiltriebbauteil als Rollenstößel zur abschaltbaren Übertragung einer Nockenerhebung auf eine Stößelstange ausgebildet sein. Dabei sind die Übertragungsglieder des Rollenstößels als hohlzylindrisches Außenteil und als zylindrisches Innenteil ausgebildet, das im Außenteil entgegen der Kraft eines Lost-Motion-Federmittels längsverschiebbar gelagert ist. Ferner sind die Koppelelemente als zwei teilzylindrische Kolben ausgebildet, die in einer hohlzylindrischen Querbohrung des Innenteils längsverschiebbar gelagert sind und jeweils einen dem Außenteil zugewandten ersten axialen Endabschnitt mit einer ebenen Kontaktfläche einer stufenförmigen Einformung aufweisen. Außerdem sind die Kraftübertragungsflächenabschnitte jedes Kolbens zum einen durch die ebene Kontaktfläche und zum anderen durch einen der Kontaktfläche radial gegenüberliegenden ersten Außenmantelabschnitt des ersten axialen Endabschnitts des Kolbens und schließlich durch einen dem ersten Außenmantelabschnitt radial gegenüberliegenden zweiten Außenmantelabschnitt eines zweiten axialen Endabschnitts des Kolbens gebildet. Dabei soll die Verschleißschutzschicht ausschließlich an den Kolben vorgesehen sein, wobei zumindest deren Kraftübertragungsflächenabschnitte mit der Verschleißschutzschicht versehen sind.

Der schaltbare Rollenstößel lässt sich in dieser Ausführungsform ausreichend verschleißbeständig und kostengünstig darstellen, da die Kohlenwasserstoffschicht lediglich auf dem Kolben mit vergleichsweise kleiner Oberfläche abgeschieden wird. Darüber hinaus sind die außen liegenden Kraftübertragungsflächenabschnitte der Kolben den für das Aufbringen der Verschleißschutzschicht vorgesehenen Beschichtungsanlagen deutlich besser zugänglich als innen liegende Kraftübertragungsflächenabschnitte, wie die innerhalb des Außenteils verlaufende Ringfläche der Ringnut oder die hohlzylindrische Querbohrung des Innenteils.

In vorteilhafter Fortbildung der Erfindung ist schließlich vorgeschlagen, dass für die Kolben 16MnCr5 oder 100Cr6 als Werkstoff vorgesehen ist. Dabei soll die Haftvermittlungsschicht zumindest nahezu vollständig aus Cr und die Zwischenschicht maximal 20% W sowie maximal 20% H enthalten.

Die Erfindung wird an nachstehendem Ausführungsbeispiel näher erläutert.

### Kurze Beschreibung der Zeichnungen

Die Erfindung ist anhand der beiliegenden Zeichnungen mit einem schaltbaren Rollenstößel als Ausführungsbeispiel für das erfindungsgemäße Ventiltriebbauteil näher erläutert. Es zeigen:
- Figur 1: den schaltbaren Rollenstößel im Längsschnitt,
- Figur 2: eine perspektivische Ansicht eines längsgeschnittenen Au- β engehäuses des Rollenstößels,
- Figur 3: eine perspektivische Ansicht eines Kolbens des Rollenstö- ßels,
- Figur 4: ein Innenteil des Rollenstößels im Längsschnitt und
- Figur 5: eine stark vergrößerte Darstellung der Ansicht A aus Figur 3 mit einem beschichteten Kraftübertragungsflächenab- schnitt.

### Ausführliche Beschreibung der Zeichnungen

In den Figuren bezeichnen gleiche Bezugszeichen gleiche oder funktionsgleiche Komponenten, soweit nichts Gegenteiliges angegeben ist.

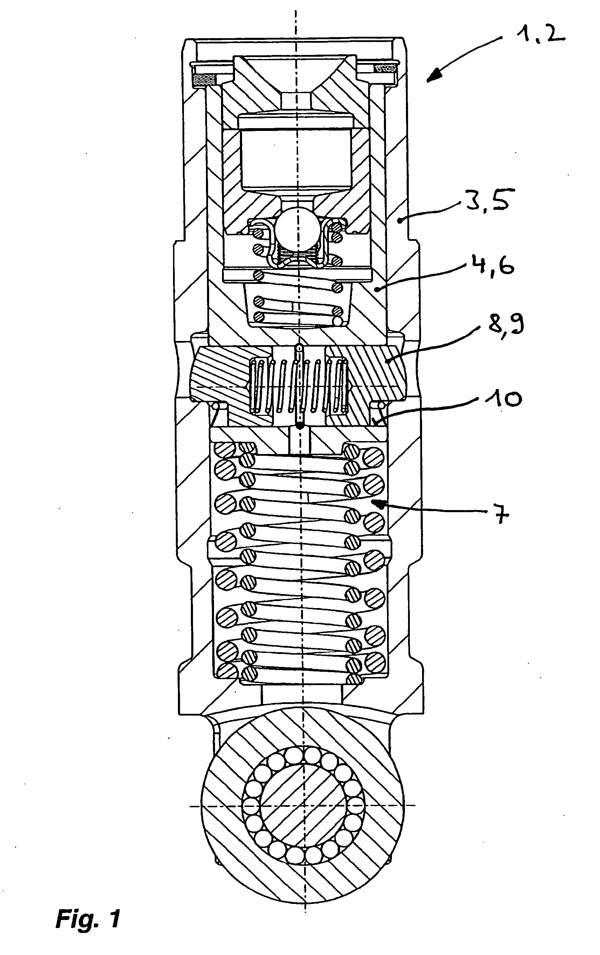

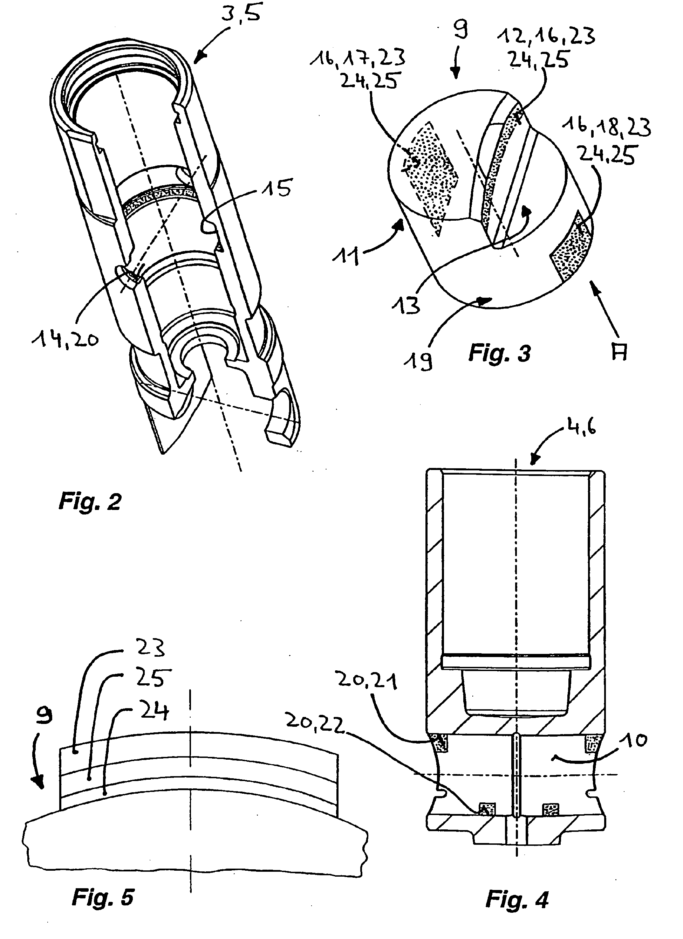

Figur 1 offenbart ein schaltbares Ventiltriebbauteil 1, das hier als Rollenstößel 2 eines Stößelstangen-Ventiltriebs mit abschaltbarer Übertragung einer nicht dargestellten Nockenerhebung ausgebildet ist. Als Übertragungsglieder 3, 4 des Rollenstößels 2 dienen ein hohlzylindrisches Außenteil 5 und ein zylindrisches Innenteil 6, das im Außenteil 5 entgegen der Kraft eines als Doppelfeder ausgebildeten Lost-Motion-Federmittels 7 längsverschiebbar gelagert ist. Das Innenteil 6 und das Außenteil 5 sind in Übertragungsrichtung mittels hydraulisch angesteuerter Koppelelemente 8 formschlüssig miteinander verbindbar. Hierzu sind die Koppelelemente 8 als zwei teilzylindrische Kolben 9 ausgebildet, die in einer hohlzylindrischen Querbohrung 10 des Innenteils 6 längsverschiebbar gelagert sind. Unter nachfolgender Einbeziehung der Figuren 2 bis 4 weist jeder Kolben 9 einen dem Außenteil 5 zugewandten ersten axialen Endabschnitt 11 mit einer ebenen Kontaktfläche 12 einer stufenförmigen Einformung 13 auf. Sofern sich der Rollenstößel 2 zur Übertragung der Nockenerhebung im verriegelten Zustand gemäß Figur 1 befindet, werden die Kolben 9 periodisch mit der Nockenerhebung zwischen einer Ringfläche 14 einer im Außenteil 5 verlaufenden Ringnut 15 und der Querbohrung 10 des Innenteils 6 eingespannt. Dabei wirken die in Figur 3 gepunktet und schematisch dargestellten Bereiche als Kraftübertragungsflächenabschnitte 16 der Kolben 9. Im einzelnen sind dies die Kontaktfläche 12, ein der Kontaktfläche 12 radial gegenüberliegender erster Außenmantelabschnitt 17 am ersten axialen Endabschnitt 11 sowie ein zweiter Außenmantelabschnitt 18 an einem zweiten axialen Endabschnitt 19 des Kolbens 9, wobei der zweite Außenmantelabschnitt 18 dem ersten Außenmantelabschnitt 17 radial gegenüberliegt.

Die mit den jeweiligen Kraftübertragungsflächenabschnitten 16 eines Kolbens 9 korrespondierenden Kraftübertragungsflächenabschnitte 20 der Übertragungsglieder 3, 4 sind in den Figuren 2 und 4 ebenfalls gepunktet dargestellt. Es handelt sich beim Außenteil 5 um die Ringfläche 14 der Ringnut 15 und beim Innenteil 6 um einen mündungsseitigen Innenmantelabschnitt 21 der Querbohrung 10, auf dem sich der erste Außenmantelabschnitt 17 des Kolbens 9 abstützt, sowie um einen dem Innenmantelabschnitt 21 radial gegenüberliegenden und den zweiten Außenmantelabschnitt 18 des Kolbens 9 abstützenden Innenmantelabschnitt 22.

Die periodisch auftretende Einspannung der Kolben 9 zwischen Ringfläche 14 und Querbohrung 10 führt zu gegenseitigen Mikrobewegungen der an der Übertragung der Nockenerhebung beteiligten Kraftübertragungsflächenabschnitte 16, 20. In Verbindung mit einem mangelhaften Schmierölfilm zwischen den Kraftübertragungsflächenabschnitten 16, 20 und/oder bei einem vergleichsweise hohen Anteil abrasiv wirkender Partikel im Schmieröl sind die Kraftübertragungsflächenabschnitte 16, 20 folglich einem erheblichen Risiko eines unzulässig hohen adhäsiven und/oder abrasiven Verschleißes ausgesetzt.

Zur Vermeidung dieses Risikos ist das Aufbringen einer Verschleißschutzschicht 23 vorgesehen. Dabei ist es bei dem dargestellten Rollenstößel 2 unter Berücksichtigung von Herstellungs- und Kostenaspekten möglich, die Verschleißschutzschicht 23 ausschließlich für die Kolben 9 vorzusehen und bei den Kraftübertragungsflächenabschnitten 20 von Innenteil 6 und Außenteil 5 auf die Verschleißschutzschicht 23 zu verzichten. Darüber hinaus kann es auch ausreichend sein, dass lediglich die Kraftübertragungsflächenabschnitte 16 der Kolben 9 beschichtet sind, wodurch sich ein ausreichender Verschleißschutz sowohl für die Kraftübertragungsflächenabschnitte 16 der Kolben 9 als auch für die Kraftübertragungsflächenabschnitte 20 von Außenteil 5 und Innenteil 6 einstellt. Dennoch können sich insbesondere in Abhängigkeit von der Geometrie der Kolben 9 und der spezifischen Ausbildung einer zum Aufbringen der Verschleißschutzschicht 23 verwendeten Beschichtungsanlage auch zwischen den Kraftübertragungsflächenabschnitten 16 verlaufende Übergangsbereiche mit von der Verschleißschutzschicht 23 abweichenden Schichtdicken ausbilden.

In Figur 5 ist die auf den zweiten Außenmantelabschnitt 18 des Kolbens 9 weisende Ansicht A mit stark vergrößerter Ausbildung der Verschleißschutzschicht 23 dargestellt. Der Kolben 9 besteht aus 100Cr6 oder 16MnCr5 und wird im letzteren Falle vor dem Beschichtungsvorgang carbonitriert und angelassen. Auf den Kolben 9 wird zunächst eine aus Cr bestehende Haftvermittlungsschicht 24 abgeschieden. Dies erfolgt mittels eines PVD-Verfahrens (Physical Vapour Deposition), wobei prozessbedingte Verunreinigungen beispielsweise infolge O- oder Ar-Atomen, Metallen oder dergleichen von bis zu 1 Atom-% tolerierbar sind. Die Haftvermittlungsschicht 24 weist eine Dicke von 0,1 µm bis 0,5 µm auf und dient einer verbesserten Anbindung einer Zwischenschicht 25 und der Verschleißschutzschicht 23 an die Kraftübertragungsflächenabschnitte 16.

Die Zwischenschicht 25 wird ebenfalls mittels eines PVD-Verfahrens auf der Haftvermittlungsschicht 24 abgeschieden und ist als metallhaltige Kohlenwasserstoffschicht (Me-C:H) mit maximal 20 % W und maximal 20 % H ausgebildet. Die Dicke der Zwischenschicht 25 beträgt etwa 0,5 µm bis 2,0 µm und dient einer verbesserten Anbringung der Verschleißschutzschicht 23 auf der Haftvermittlungsschicht 24. Die Verschleißschutzschicht 23 ist als amorphe Kohlenwasserstoffschicht (a-C:H) ausgebildet und wird vorzugsweise mittels eines PVD- und/oder (PA)CVD-Verfahrens (Plasma Assisted Chemical Vapour Deposition) auf der Zwischenschicht 25 abgeschieden.

Die aus der Haftvermittlungsschicht 24, der Zwischenschicht 25 und der Verschleißschutzschicht 23 aufgebaute Gesamtschicht besitzt eine Schichtdicke von etwa 1,0 µm bis 5,0 µm. Durch eine derartige Schichtdicke ändern sich die Abmessungen der beschichteten Kraftübertragungsflächenabschnitte 16 und gegebenenfalls 20 in einem so geringen Maße, dass keine Nachbearbeitung notwendig ist und die eingestellte Oberflächenstruktur bzw. Topographie der beschichteten Oberfläche beibehalten wird. Ebenso wenig bedarf die amorphe Kohlenwasserstoffschicht einer nachträglichen Wärmebehandlung. Bei den so beschichteten Kolben 9 werden die tribologischen Aufgaben, nämlich die Verschleißbeständigkeit der Kraftübertragungsflächenabschnitte 16, 20 bei gleichzeitiger Reduzierung des Reibkoeffizienten von der Verschleißschutzschicht 23 übernommen, während die mechanischen Aufgaben vom Kolben 9 übernommen werden.

Der niedrige Reibkoeffizient der Verschleißschutzschicht 23 führt außerdem auch zu einer deutlichen Reibungsreduzierung der Kolben 9 zugunsten einer erhöhten Verlagerungsgeschwindigkeit der Kolben 9 innerhalb der Querbohrung 10 des Innenteils 6. Dies gewährleistet einen ausreichend schnellen und reproduzierbaren Umschaltvorgang des Rollenstößels 2 auch bei hohen Drehzahlen der Brennkraftmaschine.

**Liste der Bezugszahlen**
- 1: Ventiltriebbauteil
- 2: Rollenstößel
- 3: Übertragungsglied
- 4: Übertragungsglied
- 5: Außenteil
- 6: Innenteil
- 7: Lost-Motion-Federmittel
- 8: Koppelelement
- 9: Kolben
- 10: Querbohrung
- 11: erster axialer Endabschnitt
- 12: Kontaktfläche
- 13: Einformung
- 14: Ringfläche
- 15: Ringnut
- 16: Kraftübertragungsflächenabschnitt
- 17: erster Außenmantelabschnitt
- 18: zweiter Außenmantelabschnitt
- 19: zweiter axialer Endabschnitt
- 20: Kraftübertragungsflächenabschnitt
- 21: Innenmantelabschnitt
- 22: Innenmantelabschnitt
- 23: Verschleißschutzschicht
- 24: Haftvermittlungsschicht
- 25: Zwischenschicht

## Patentansprüche

1. Schaltbares Ventiltriebbauteil (1) zur variablen Übertragung eines von einer oder mehreren Nockenerhebungen erzeugten Hubes auf wenigstens ein Gaswechselventil einer Brennkraftmaschine, mit mindestens zwei Übertragungsgliedern (3, 4), die durch ein oder mehrere Koppelelemente (8) in Übertragungsrichtung formschlüssig verbindbar sind, indem Kraftübertragungsflächenabschnitte (16) der Koppelelemente (8) zwischen Kraftübertragungsflächenabschnitten (20) der Übertragungsglieder (3, 4) einspannbar sind, **dadurch gekennzeichnet, dass** zumindest einer der Kraftübertragungsflächenabschnitte (16, 20) mit einer Verschleißschutzschicht (23) versehen ist, die aus mindestens einer metallfreien amorphen Kohlenwasserstoffschicht besteht, wobei zwischen dem zumindest einen der Kraftübertragungsflächenabschnitte (16, 20) und der Verschleißschutzschicht (23) wenigstens eine Zwischenschicht (25) vorgesehen ist, die als metallhaltige Kohlenwasserstoffschicht, deren Metallkomponenten aus W, Ti, Hf, Ge oder einer Kombination der vorgenannten Komponenten bestehen, ausgebildet ist und eine Dicke von etwa 0,5 µm bis 2,0 µm aufweist.

2. Ventiltriebbauteil nach Anspruch 1, **dadurch gekennzeichnet, dass** die amorphe Kohlenwasserstoffschicht einen Wasserstoffanteil von maximal 16 Atom-% und prozessbedingte Verunreinigungen von weniger als 1 Atom-% aufweist.

3. Ventiltriebbauteil nach Anspruch 1 oder 2, **dadurch gekennzeichnet, dass** die amorphe Kohlenwasserstoffschicht eine Dicke von etwa 0,8 pm bis 2,5 µm aufweist.

4. Ventiltriebbauteil nach Anspruch 1, **dadurch gekennzeichnet, dass** zwischen dem zumindest einen der Kraftübertragungsflächenabschnitte (16, 20) und der Zwischenschicht (25) wenigstens eine Haftvermittlungsschicht (24) vorgesehen ist.

5. Ventiltriebbauteil nach Anspruch 4, **dadurch gekennzeichnet, dass** die wenigstens eine Haftvermittlungsschicht (24) aus metallischen Stoffen, Boriden, Carbiden und/oder Nitriden der Übergangsmetalle besteht und eine Dicke von etwa 0,1 µm bis 0,5 µm aufweist.

6. Ventiltriebbauteil nach Anspruch 4, **dadurch gekennzeichnet, dass** das Ventiltriebbauteil (1) als Rollenstößel (2) zur abschaltbaren Übertragung einer Nockenerhebung auf eine Stößelstange ausgebildet ist und folgende Merkmale aufweist:
■ als Übertragungsglieder (3, 4) des Rollenstößels (2) dienen ein hohlzylindrisches Außenteil (5) und ein zylindrisches Innenteil (6), das im Außenteil (5) entgegen der Kraft eines Lost-Motion-Federmittels (7) längsverschiebbar gelagert ist;
■ die Koppelelemente (8) sind als zwei teilzylindrische Kolben (9) ausgebildet, die in einer hohlzylindrischen Querbohrung (10) des Innenteils (6) längsverschiebbar gelagert sind und jeweils einen dem Außenteil (5) zugewandten ersten axialen Endabschnitt (11) mit einer ebenen Kontaktfläche (12) einer stufenförmigen Einformung (13) aufweisen;
■ die Kraftübertragungsflächenabschnitte (16) jedes Kolbens (9) sind durch die ebene Kontaktfläche (12), durch einen der Kontaktfläche (12) radial gegenüberliegenden ersten Außenmantelabschnitt (17) des ersten axialen Endabschnitts (11) sowie durch einen dem ersten Außenmantelabschnitt (17) radial gegenüberliegenden zweiten Außenmantelabschnitt (18) eines zweiten axialen Endabschnitts (19) des Kolbens (9) gebildet, und
■ die Verschleißschutzschicht (23) ist ausschließlich an den Kolben (9) vorgesehen, wobei zumindest deren Kraftübertragungsflächenabschnitte (16) mit der Verschleißschutzschicht (23) versehen sind.

7. Ventiltriebbauteil nach Anspruch 6, **dadurch gekennzeichnet, dass** für die Kolben (9) 16MnCr5 oder 100Cr6 als Werkstoff vorgesehen ist, wobei die Haftvermittlungsschicht (24) zumindest nahezu vollständig aus Cr und die Zwischenschicht (25) maximal 20% W sowie maximal 20% H enthält.

## Claims

1. Switchable valve drive component (1) for the variable transmission of a stroke generated by one or more cam elevations to at least one gas exchange valve of an internal combustion engine, with at least two transmission members (3, 4) which are connectable positively in a transmission direction by means of one or more coupling elements (8), in that force transmission surface portions (16) of the coupling elements (8) are clampable between force transmission surface portions (20) of the transmission members (3, 4), **characterized in that** at least one of the force transmission surface portions (16, 20) is provided with a wear protection layer (23) which consists of at least one metal-free amorphous hydrocarbon layer, there being provided between the at least one of the force transmission surface portions (16, 20) and the wear protection layer (23) at least one intermediate layer (25) which is formed as a metal-containing hydrocarbon layer, the metal components of which consist of W, Ti, Hf, Ge or a combination of the abovementioned components, and has a thickness of about 0.5 µm to 2.0 µm.

2. Valve drive component according to Claim 1, **characterized in that** the amorphous hydrocarbon layer has a hydrogen fraction of at most 16 atomic % and process-induced impurities of less 1 atomic %.

3. Valve drive component according to Claim 1 or 2, **characterized in that** the amorphous hydrocarbon layer has a thickness of about 0.8 µm to 2.5 µm.

4. Valve drive component according to Claim 1, **characterized in that** at least one adhesion promoter layer (24) is provided between the at least one of the force transmission surface portions (16, 20) and the intermediate layer (25).

5. Valve drive component according to Claim 4, **characterized in that** the at least one adhesion promoter layer (24) consists of metallic materials, borides, carbides and/or nitrides of the transition metals and has a thickness of about 0.1 µm to 0.5 µm.

6. Valve drive component according to Claim 4, **characterized in that** the valve drive component (1) is designed as a roller tappet (2) for the disconnectable transmission of a cam elevation to a tappet rod and has the following features:
• the transmission members (3, 4) of the roller tappet (2) are a whole-cylindrical outer part (5) and a cylindrical inner part (6) which is mounted in the outer part (5) so as to be longitudinally displaceable counter to the force of a lost-motion spring means (7);
• the coupling elements (8) are designed as two part-cylindrical pistons (9) which are mounted so as to be longitudinally displaceable in a hollow-cylindrical transverse bore (10) of the inner part (6) and have in each case a first axial end portion (11) facing the outer part (5) and having a planar contact surface (12) of a step-like recessed formation (13);
• the force transmission surface portions (16) of each piston (9) are formed by the planar contact surface (12), by a first outer surface area portion (17), lying radially opposite the contact surface (12), of the first axial end portion (11), and by a second outer surface area portion (18), lying radially opposite the first outer surface area portion (17), of a second axial end portion (19) of the piston (9), and
• the wear protection layer (23) being provided solely on the pistons (9), at least the force transmission surface portions (16) of the latter being provided with the wear protection layer (23).

7. Valve drive component according to Claim 6, **characterized in that** the material provided for the pistons (9) is 16MnCr5 or 100Cr6, the adhesion promoter layer (24) consisting at least approximately completely of Cr, and the intermediate layer (25) containing at most 20% W and at most 20% H.

## Revendications

1. Poussoir de soupape désactivable (1) pour la transmission variable d'une levée produite par une ou plusieurs surélévations de came sur au moins une soupape à gaz à deux voies d'un moteur à combustion interne, avec au moins deux organes de transmission (3, 4) qui peuvent être assemblés par emboîtement dans la direction de transmission au moyen d'un ou de plusieurs éléments de couplage (8), du fait que des parties de surface de transmission de force (16) des éléments de couplage (8) peuvent être serrées entre des parties de surface de transmission de force (20) des organes de transmission (3, 4), **caractérisé en ce qu'**au moins une des parties de surface de transmission de force (16, 20) est munie d'une couche de protection contre l'usure (23), qui se compose d'au moins une couche d'hydrocarbure amorphe sans métal, dans lequel il est prévu entre ladite au moins une des parties de surface de transmission de force (16, 20) et la couche de protection contre l'usure (23) au moins une couche intermédiaire (25), qui est réalisée sous la forme d'une couche d'hydrocarbure contenant du métal, dont les composants métalliques sont constitués de W, Ti, Hf, Ge ou d'une combinaison des composants précités, et présente une épaisseur d'environ 0,5 µm à 2,0 µm.

2. Poussoir de soupape selon la revendication 1, **caractérisé en ce que** la couche d'hydrocarbure amorphe présente une proportion d'hydrogène de 16 % atomiques au maximum et des impuretés dues au procédé de moins de 1 % atomique.

3. Poussoir de soupape selon la revendication 1 u 2, **caractérisé en ce que** la couche d'hydrocarbure amorphe présente une épaisseur d'environ 0,8 µm à 2,5 µm.

4. Poussoir de soupape selon la revendication 1, **caractérisé en ce qu'**il est prévu au moins une couche d'agent adhésif (24) entre ladite au moins une des parties de surface de transmission de force (16, 20) et la couche intermédiaire (25).

5. Poussoir de soupape selon la revendication 4, **caractérisé en ce que** ladite au moins une couche d'agent adhésif (24) se compose de matières métalliques, de borures, de carbures et/ou de nitrures des métaux de transition et présente une épaisseur d'environ 0,1 µm à 0,5 µm.

6. Poussoir de soupape selon la revendication 4, **caractérisé en ce que** le poussoir de soupape (1) est réalisé sous la forme d'un poussoir à galets (2) pour la transmission désactivable d'une surélévation de came à une tige de poussoir et présente les caractéristiques suivantes:
• comme organes de transmission (3, 4) du poussoir à galets (2), on utilise une pièce extérieure cylindrique creuse (5) et une pièce intérieure cylindrique (6), qui est montée dans la pièce extérieure (5) de façon longitudinalement coulissante contre la force d'un moyen de ressort à course morte (7);
• les éléments de couplage (8) sont réalisés sous la forme de deux pistons partiellement cylindriques (9), qui sont montés de façon longitudinalement coulissante dans un alésage transversal cylindrique creux (10) de la pièce intérieure (6) et qui présentent respectivement une première partie d'extrémité axiale (11) tournée vers la pièce extérieure (5) avec une face de contact plane (12) d'un épaulement étagé (13);
• les parties de surface de transmission de force (16) de chaque piston (9) sont formées par la face de contact plane (12), par une première partie latérale extérieure (17) de la première partie d'extrémité axiale (11) radialement opposée à la face de contact (12) ainsi que par une partie latérale extérieure (18) d'une deuxième partie d'extrémité axiale (19) du piston (9) radialement opposée à la première partie latérale extérieure (17), et
• la couche de protection contre l'usure (23) est prévue exclusivement sur les pistons (9), dans lequel au moins les parties de surface de transmission de force (16) de ceux-ci est munie de la couche de protection contre l'usure (23).

7. Poussoir de soupape selon la revendication 6, **caractérisé en ce qu'**il est prévu comme matériau pour les pistons (9) du 16MnCr5 ou du 100Cr6, dans lequel la couche d'agent adhésif (24) se compose au moins à peu près entièrement de Cr et la couche intermédiaire (25) contient au maximum 20 % W ainsi qu'au maximum 20 % H.
